(19) **Europäisches Patentamt**
**European Patent Office**
**Office européen des brevets**

(11) **EP 3 318 993 B1**

(12) **EUROPEAN PATENT SPECIFICATION**

(45) Date of publication and mention
of the grant of the patent:
**24.08.2022 Bulletin 2022/34**

(21) Application number: **15896926.1**

(22) Date of filing: **22.09.2015**

(51) International Patent Classification (IPC):
**G06F 30/15** (2020.01)    **G06F 30/20** (2020.01)
**H01Q 1/12** (2006.01)    **H01Q 15/16** (2006.01)
**H01Q 1/28** (2006.01)

(52) Cooperative Patent Classification (CPC):
**H01Q 1/1235; G06F 30/15; G06F 30/20;**
**H01Q 15/161;** H01Q 1/288

(86) International application number:
**PCT/CN2015/090222**

(87) International publication number:
**WO 2017/000396 (05.01.2017 Gazette 2017/01)**

(54) **TRUSS ANTENNA REFLECTOR DEPLOYMENT DYNAMICS MODELLING METHOD BASED ON MULTI-BODY ANALYSIS TEST**

VERFAHREN ZUR MODELLIERUNG DER EINSATZDYNAMIK EINES GITTERANTENNENREFLEKTORS AUF DER GRUNDLAGE EINES MULTIKÖRPERANALYSETESTS

PROCÉDÉ DE MODÉLISATION DE DYNAMIQUE DE DÉPLOIEMENT DE RÉFLECTEUR D'ANTENNE EN TREILLIS BASÉ SUR UN ESSAI D'ANALYSE MULTI-CORPS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2015 CN 201510374365**

(43) Date of publication of application:
**09.05.2018 Bulletin 2018/19**

(73) Proprietor: **China Academy of Space Technology**
**Beijing 100094 (CN)**

(72) Inventors:
• **ZHOU, Zhicheng**
**Beijing 100094 (CN)**
• **SUN, Baoxiang**
**Beijing 100094 (CN)**
• **DONG, Fuxiang**
**Beijing 100094 (CN)**
• **QIU, Lede**
**Beijing 100094 (CN)**
• **YUAN, Jungang**
**Beijing 100094 (CN)**
• **HU, Di**
**Beijing 100094 (CN)**
• **LIU, Min**
**Beijing 100094 (CN)**

(74) Representative: **Piticco, Lorena**
**Isler & Pedrazzini AG**
**Giesshübelstrasse 45**
**Postfach 1772**
**8027 Zürich (CH)**

(56) References cited:
**CN-A- 104 133 932    JP-A- 2010 086 092**
**US-A1- 2005 209 835**

• **JIN MITSUGI ET AL: "Deployment analysis of large space antenna using flexible multibody dynamics simulation", ACTA ASTRONAUTICA, vol. 47, no. 1, 24 July 2000 (2000-07-24), pages 19-26, XP055557557, GB ISSN: 0094-5765, DOI: 10.1016/S0094-5765(00)00014-X**
• **ZHIGANG XING ET AL: "Deploying process modeling and attitude control of a satellite with a large deployable antenna", CHINESE JOURNAL OF AERONAUTICS, vol. 27, no. 2, 25 February 2014 (2014-02-25), pages 299-312, XP055555573, AMSTERDAM, NL ISSN: 1000-9361, DOI: 10.1016/j.cja.2014.02.004**

EP 3 318 993 B1

- XU YAN ET AL: "Kinematic analysis of the deployable truss structures for space applications", JOURNAL OF AEROSPACE TECHNOLOGY AND MANAGEMENT, vol. 4, no. 4, October 2012 (2012-10), pages 453-462, XP055557502, DOI: 10.5028/jatm.2012.04044112
- DONG, FUXIANG ET AL.: 'Deployment Dynamics Modeling and Simulation of Satellite Large Antenna Reflector Truss' SPACECRAFT ENGINEERING vol. 21, no. 4, 15 August 2012, pages 26 - 28, XP009504632

## Description

The present application claims the priority to Chinese Patent Application No. 201510374365.5, titled "TRUSS ANTENNA REFLECTOR DEPLOYMENT DYNAMICS MODELLING METHOD BASED ON MULTI-BODY ANALYSIS TEST", filed on June 30, 2015 with the Chinese State Intellectual Property Office.

## TECHNICAL FIELD

The present disclosure relates to truss antenna reflector deployment dynamics and control method based on a multi-body analysis test, particularly to a truss antenna reflector deployment dynamics modeling method based on a multi-body analysis test, which belongs to the field of spacecraft dynamics and control technology.

## BACKGROUND

A flexible satellite-borne multi-body truss mesh antenna mainly includes a large deployable mast, a small deployable mast, a reflector, and a focal-plane feed array. Deployment of a large satellite-borne truss mesh antenna includes deployment of the large deployable mast, deployment of the small deployable mast and deployment of the reflector. After the deployment of the large deployable mast and the deployment of the small deployable mast finish, the deployment of the reflector starts. The reflector deploys under the action of a coil spring, and meanwhile two drive motors installed on the antenna start withdrawing cables (which is also referred to as drive cords) simultaneously. The deployment of the reflector is no longer accelerated when driving moment of the coil spring is equal to resistance moment. When the resistance moment is greater than the driving moment of the coil spring, the deployment of the reflector is decelerated and soon stopped. Then the motors drag the cables in truss diagonal rods to drive the reflector to continue deploying, until the reflector of the antenna is deployed completely. Therefore, the coil spring, the two drive motors and the cables constitute a drive mechanism of the reflector of the antenna. Since the reflector includes a reflection net, a cable net, the coil spring, the cable, a T-shaped hinge having a cable sheave, a synchronous hinge having an escapement for controlling a release speed of the coil spring, a diagonal rod locking hinge including a sliding hinge and an in-position locking mechanism, a vertical rod, a transversal rod and other component, for example, there are more than 150 truss rods, more than 90 hinges and thousands of both cables and net cables, which is very complicated, multi-body dynamics simulation software for the deployment of the reflector of the flexible satellite-borne multi-body truss mesh antenna is complicated, resulting in a large amount of calculation and large time consumption for the calculation. With the development of the flexible satellite-borne multi-body truss mesh antenna, flexible multi-body dynamics is combined with calculation methods and software engineering, forming a new branch of discipline for calculating multi-body system dynamics.

In design of the satellite-borne truss mesh antenna, in order to ensure the security of a deployment process of the flexible multi-body truss mesh antenna, especially ensure enough stress margin for all truss rods, hinges, cables and net cables in a deployment process of a reflector in a large antenna, multi-body dynamics simulation analysis and deployment tests of a large deployable mast, a small deployable mast and a reflector in the large antenna are performed, which are needed in design and development for a structure of the flexible multi-body truss mesh antenna. However, it is not provided a simplified dynamics model for the deployment process of the reflector in the satellite-borne truss mesh antenna, which is needed in controller design, test and analysis for a control system controlling the deployment process of the reflector in a deployment mode of the large antenna. The deployment process of the reflector directly affects the satellite. Control system design and test simulation software highly requires a real-time performance, and thus cannot be realized by copying the complicated model for calculating multi-body system dynamics of the deployment of the reflector. However, research on how to model thousands of components in the deployment process of the reflector and how to model a driving force and driving moment of the reflector in the control system design, test and simulation software is not yet found at present in any dissertations or patents. For example, Mitsugi et al discloses deployment analysis of a large space antenna composed of a reflective mesh, a cable network and a deployable truss structure based on flexible multibody dynamics in "Deployment analysis of large space antenna using flexible multibody dynamics simulation", ACTA ASTRONAUTICA, vol.47, no. 1, 24 July 2000, pp. 19-26. However, D1 fails to address the issue as described above.

## SUMMARY

A technical problem to be solved according to the present disclosure is to provide a truss antenna reflector deployment dynamics modeling method based on a multi-body analysis test to overcome the disadvantage in the conventional technology. In the present disclosure, more than hundreds of components in a reflector are converted into dozens of equivalent mass units with taking hinges as cores. By obeying the law of whole-satellite (a whole satellite) angular momentum conservation without the action of external moment and conforming to principles of position time history equivalence, mass property equivalence and force condition equivalence, a simplified dynamics model and a database for control system design and test simulation are obtained from results of simulation analysis performed by multi-body dynamics simulation software, thereby solving the interdisciplinary cross-satellite multi-system problem. Furthermore, the simplified dynamics model obtained according to the present disclosure can not only be used in the control system design and test simulation with self-correcting, but also be used for fault analysis and troubleshooting in a deployment process of the reflector, which has both novelty and industrial applicability.

The invention is set out in the appended set of claims in the disclosure..

Compared with conventional technology, the present disclosure has advantageous effects as follows.

(1) In the present disclosure, hundreds of thousands of physical components in the multi-body dynamic simulation analysis are converted into dozens of equivalent mass units with taking hinges as cores. Under the condition of obeying the law of whole-satellite angular momentum conservation without the action of external moment and conforming to principles of mass property equivalence and force condition equivalence, the simplified dynamics model and the database for the control system design and test simulation are obtained by analyzing results of simulation analysis performed by multi-body dynamics simulation software, thereby solving the interdisciplinary cross-satellite multi-system problem. Also the simplified dynamics model obtained can not only be used in the control system design and test simulation with self-correcting, but also be used for fault analysis and troubleshooting in the deployment process of the reflector, which has both novelty and industrial applicability.

(2) When making equivalence to the hundreds of thousands of physical components, the number of the equivalent mass units is selected to be equal to the number of jointing points of the vertical rods, the transversal rods and the diagonal rods. When a force vector time history of any equivalent mass unit changes, a motion trajectory of a jointing point of the vertical rod, the transversal rod and the diagonal rod corresponding to the equivalent mass unit in the deployment process of the reflector changes. The simplified dynamics model obtained in this way is an optimum simplified model having fault analysis and troubleshooting ability, thereby greatly improving reliability and operating efficiency of the antenna reflector.

## BRIEF DESCRIPTION OF THE DRAWINGS

Figure 1 is a flowchart of a method according to the present disclosure;

Figure 2 is a schematic diagram of an in-orbit operating state of a satellite-borne truss antenna according to an embodiment of the present disclosure;

Figure 3 is schematic diagrams of a truss antenna reflector in a furled state and a deployed state according to an embodiment of the present disclosure;

Figure 4 is schematic diagrams of a truss structure, the numbering of 30 vertical rod and a coordinate system according to an embodiment of the present disclosure;

Figure 5 is a schematic diagram of positions of measuring points during deployment test of a truss antenna reflector according to an embodiment of the present disclosure; and

Figure 6 is a front view and a top view of motion trajectories of centers of mass of deployable truss transversal rods in a reflector reference coordinate system in a deployment process of a truss antenna reflector according to an embodiment of the present disclosure.

## DETAILED DESCRIPTION OF THE EMBODIMENTS

Operation principles and operation processes of the technical solution are explained and illustrated below with reference to the drawings.

A flexible satellite-borne multi-body truss antenna mainly includes a large deployable mast, a small deployable mast, a reflector, and a focal-plane feed array. Deployment of the satellite-borne truss mesh antenna includes deployment of the large deployable mast, deployment of the small deployable mast and deployment of the reflector. After the deployment of the large deployable mast and the deployment of the small deployable mast finish, the deployment of the reflector starts. The reflector deploys under the action of a coil spring, and meanwhile two drive motors installed on the antenna start withdrawing cables (which is also referred to as driving cords) simultaneously. The deployment of the reflector is no longer accelerated when driving moment of the coil spring is equal to resistance moment. When the resistance moment is greater than the driving moment of the coli spring, the deployment of the reflector decelerates and soon stopped. Then the motors drag the cables in truss diagonal rods to drive the reflector to continue deploying, until the reflector of the antenna is deployed completely. Therefore the coil spring, the two drive motors and the cables constitute a drive mechanism of the reflector of the antenna. Since the reflector includes a reflection net, a cable net, the coil spring, the cable (the drive cord), a T-shaped hinge having a cable sheave, a synchronous hinge having an escapement for controlling a release speed of the coil spring, a diagonal rod locking hinge including a sliding hinge and an in-position locking mechanism, a vertical rod, a transversal rod (an upper transversal rod and a lower transversal rod) and other component, for example, a general large flexible multi-body truss mesh antenna includes more than 150 truss rods, more than 90 hinges and thousands of both cables and net cables, which is very complicated, multi-body dynamics simulation analysis software for the deployment of the reflector of the large satellite-borne truss mesh antenna is complicated, resulting in a large amount of calculation. It will take three days for the latest workstation to perform simulation analysis on a deployment process of the reflector. According to the present disclosure, it is provided a method for building a simplified inertia time-varying and force time-varying dynamics model and a database needed in control system design, test and simulation analysis software on a basis of a result of simulation analysis obtained by multi-body dynamics software and a measurement result of a test for a complicated deployment model of the flexible satellite-borne multi-body truss mesh antenna reflector.

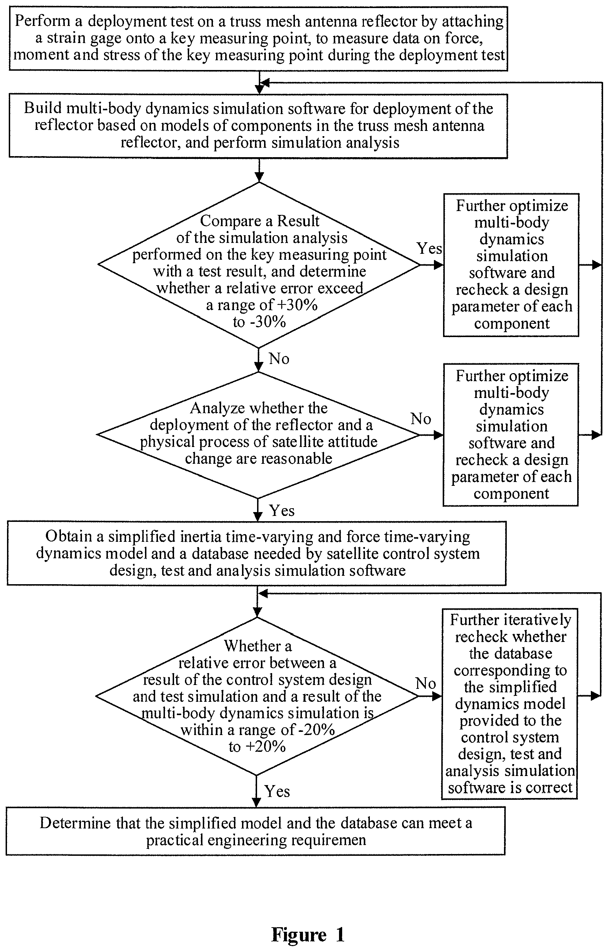

As shown in Figure 1, a truss antenna reflector deployment dynamics modeling method based on a multi-body analysis test provided according to the present disclosure includes steps (1) to (7).

In step (1), in order to ensure security of a deployment process of a flexible multi-body truss mesh antenna reflector, a deployment test is performed on the flexible multi-body truss mesh antenna reflector. A strain gage is attached onto a key measuring point, to measure data on force, moment and stress of the key measuring point during the deployment test, for verifying whether a structure design parameter and a stress margin of the key measuring point meet design requirements, and verifying correctness of a result of analysis performed by multi-body dynamics simulation software.

In step (2), in order to ensure that both stress and a motion trajectory of any point of each of components in the deployment process of the truss mesh antenna reflector meet security requirements, multi-body dynamics simulation software is built based on characteristic models of the components in the truss mesh antenna reflector, and simulation analysis is performed on data on force, moment and stress of the key measuring point and a force-bearing point of each of the components concerned by a structure designer. The characteristic models of the components include a reflector coil spring passive drive mechanism model, a cable sheave active drive mechanism model, and a typical hinge friction model.

In step (3), a result of the multi-body dynamics simulation analysis performed on the force, the moment and the stress of the key measuring point is compared with a measurement result of the deployment test in step (1), and in a case that a comparison result indicates that a relative error between the result of the multi-body dynamics simulation analysis and the measurement result exceeds a range of +30% to -30%, the multi-body dynamics simulation software built in step (2) is optimized by rechecking whether the structure design parameter of each of the components in the multi-body dynamics simulation software is complete and correct.

For example, if flexibility parameters of the vertical rods, the transversal rods and other component are not taken into account when comparing the result of the multi-body dynamics simulation analysis with the measurement result, the result of the simulation is more than 50% greater than the measurement result of deployment test. In this case, the multi-body dynamics simulation software built in step (2) is optimized, that is, the flexibility parameters of the vertical rods, the transversal rods and other component are taken into account.

Since driving forces and friction coefficients of drive components (such as the coil spring, the motors, and the cables) for deployment of the reflector and practical properties of a truss rod, a hinge, an escapement and other component are impossible to be completely consistent with each other, practical motion trajectories of hinge points are not ideal space curves, but non-synchronous space curves, in the deployment test. Since an input to the multi-body dynamics simulation analysis is usually design parameters, a relative error ranging from -30% to +30% is allowed in the comparison result for the force, the moment and the stress of the measuring point, which is a normal error range for force parameter allowed in practical engineering.

In step (4), in a case that the comparison result indicates that the relative error is within a predetermined threshold range A, whether a physical process of satellite attitude change is reasonable is analyzed based on a satellite attitude change result and a motion trajectory of center of mass of each of the components in the reflector which are provided by the multi-body dynamics simulation software without wheel control and solar pressure disturbance moment. In a case that the physical process of satellite attitude change is unreasonable, the multi-body dynamics simulation software built in step (2) is optimized by rechecking whether the structure design parameter of each of the components in the reflector in the multi-body dynamics simulation software is complete and correct. The analysis of whether the physical process of satellite attitude change is reasonable includes analyzing whether whole-satellite angular momentum obeys the law of whole-satellite angular moment conservation, and whether the motion trajectory of center of mass of each of the components meets an operating condition (the operating condition is usually referred to as a simulation setting scenario in computer simulation analysis) for a normal or faulty antenna reflector deployment set in the multi-body dynamics simulation.

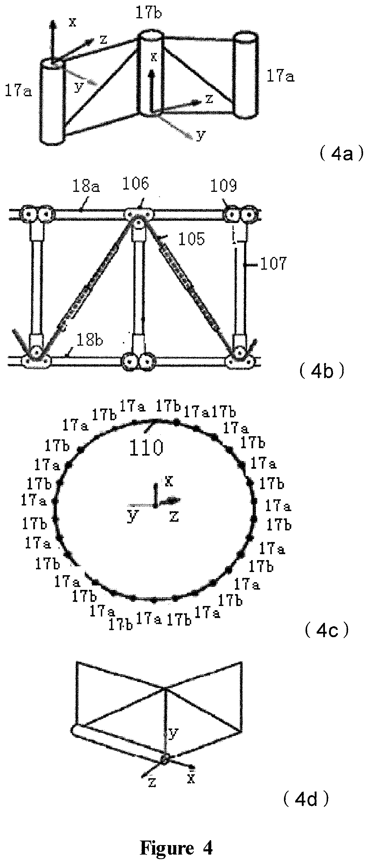

In step (5), in a case that both the deployment of the antenna reflector and the physical process of the satellite attitude change obeys the law of angular momentum conservation, and the motion trajectory of the center of mass of each of the components meets the operating condition for a normal or faulty antenna reflector deployment set in the simulation, multiple equivalent mass units are constructed, without damaging a truss structure, from a large number (more than hundreds) of components of the reflector by combining each hinge of the reflector as a core with an adjacent transversal rod, an adjacent vertical rod and an adjacent diagonal rod (A motion trajectory of any point of the truss structure in a satellite mechanical coordinate system and a force condition of the point in a component floating coordinate system can be obtained by the multi-body dynamics simulation analysis. In order to extract a simplified dynamics model and a database, it is necessary to construct multiple equivalent mass units to the reflector. As shown by a truss structure in Figure 4, an equivalent mass unit may be constructed by combining a synchronous hinge having a control coil spring on the top of a vertical rod as a core, with an adjacent upper transversal rod and the vertical rod. Another equivalent mass unit may be constructed by combining a T-shaped hinge having a cable sheave at bottom of the vertical rod as a core with an adjacent lower transversal rod and an adjacent diagonal rod having a drive cord running through. In the embodiment, the truss reflector includes 30 vertical rods, and thus 60 equivalent mass units are constructed). Then, a position time history, a velocity time history, an acceleration time history, and a force vector time history of center of mass of each of the equivalent mass units are obtained by the multi-body dynamics simulation software using the Runge-Kutta method, and then a simplified inertia time-varying and force time-varying dynamics model and a database needed by satellite control system design, test and analysis simulation software are obtained through coordinate transformation. Whether a selected sampling period of the Runge-Kutta method in the multi-body dynamics simulation software is reasonable may be verified with an inverse solution method of motion characteristic equivalence.

An example of verifying whether the selected sampling period of the Runge-Kutta method used by the multi-body dynamics simulation software is reasonable using the inverse solution method of motion characteristic equivalence is described below. An initial position, an ending position and an initial velocity of a sampling period are obtained based on the position time history and the velocity time history of an equivalent mass unit. Then, an approximate uniform acceleration of position equivalence in the sampling period is calculated according to a linear motion equation. If the sampling period of the multi-body dynamics simulation software is small enough, an error between the inversely solved uniform acceleration of the sampling period and an acceleration obtained with the Runge-Kutta method used in the multi-body dynamics simulation software is smaller than 20%, thereby ensuring deployment position equivalence of the antenna reflector and meeting practical engineering requirements.

A motion trajectory of any point of the truss structure in the satellite mechanical coordinate system and a force condition of the point in the component floating coordinate system can be obtained by the multi-body dynamics simulation analysis. The database includes a position time history of each of the equivalent mass units in a satellite mechanical coordinate system, a position time history of center of mass of a whole satellite in the satellite mechanical coordinate system, a velocity time history of each of the equivalent mass units relative to the satellite mechanical coordinate system, an acceleration time history of each of the equivalent mass units relative to the satellite mechanical coordinate system, a reaction force vector time history of each of the equivalent mass unit on the satellite, a reaction moment vector time history of each of the equivalent mass units relative to a satellite body coordinate system, a rotational inertia time history of each of the equivalent mass units relative to the satellite body coordinate system, an angular momentum vector time history of each of the equivalent mass units relative to the satellite body coordinate system, a rotational inertia time history of the whole satellite relative to the satellite body coordinate system, and a resultant reaction moment vector time history (a resultant reaction moment vector time history of 60 equivalent mass units relative to the satellite body coordinate system is adopted in the embodiment) of the equivalent mass units relative to the satellite body coordinate system;

The simplified dynamics model is obtained by replacing, in an original attitude dynamics equation in the control system design test and analysis simulation software, a disturbance moment and an inertia matrix of the whole satellite relative to center of mass of the whole satellite in the original attitude dynamics equation respectively with the resultant reaction moment vector time history of the equivalent mass units relative to the satellite body coordinate system and the rotational inertia time history of the whole satellite relative to the satellite body coordinate system which are obtained from the analysis performed by the multi-body dynamics simulation software.

The original attitude dynamics equation in the control system design, test and analysis simulation software are represented as follows:

$$m_T \frac{dV_T}{dt} + \sum_{i=1}^{m} \beta_{ti} \ddot{q}_i = F$$

$$I_T \dot{\omega} + \dot{h} + \omega \times h + \sum_{i=1}^{m} \beta_{ri} \ddot{q}_i = T_{SAT}$$

$$\ddot{q}_i + 2\rho_i \Lambda_i \dot{q}_i + \Lambda_i^2 q_i + \beta_{ti}^T \frac{dV}{dt} + \beta_{ri}^T \dot{\omega} = 0$$

$I_T$ represents an inertia matrix of the whole satellite having no deformed flexible appendage relative to center of mass of the whole satellite ( $I_T$ is replaced with the rotational inertia time history of the whole satellite relative to the satellite body coordinate system), $T_{SAT}$ represents moment on the satellite relative to center of mass of the whole satellite before deformation of flexible appendages, and is a three-dimensional vector ($T_{SAT}$ is replaced with the resultant reaction moment vector time history of the equivalent mass units relative to the satellite body coordinate system), $m_T$ represents mass of the whole satellite, $V_T$ represents a velocity of center of mass of the whole satellite having no deformed flexible appendage and is a three-dimensional vector, h represents angular momentum of a momentum wheel and is a three-dimensional vector, qi represents modal coordinates of the i-th flexible appendage and is a m-dimensional vector, $\beta_{ti}$ represents a translational coupling coefficient of the i-th flexible appendage, $\beta_{ri}$ represents a rotational coupling coefficient of the i-th flexible appendage, F represents an external force on the satellite, $\rho_i$ represents a modal damping ratio of the i-th flexible appendage, $\Lambda_i$ represents a modal frequency of the i-th flexible appendage, m represents the number of modal coordinates of the flexible appendages, $\beta_{ti}$, $\beta_{ri}$, and $\rho_i$ can be obtained with a finite element method, and the modal damping ratio generally ranges from 0.005 to 0.01, $\omega$ represents an attitude angular velocity, and V represents a translational velocity of the whole satellite.

Each jointing point of the rods, the transversal rods and the diagonal rods in the reflector is provided with a hinge which has the most mass and subjects to the maximum force, and is a mark point of deformation in the deployment process of the reflector. Therefore, the number of the equivalent mass units is selected to be equal to the number of the jointing points of the vertical rods, the transversal rods and the diagonal rods. If a force vector time history of any equivalent mass unit changes, a motion trajectory of a jointing point of the vertical rod, the transversal rod, and the diagonal rod corresponding to the equivalent mass unit in the deployment process of the reflector changes. Therefore, such simplified dynamics model is an optimum simplified model having fault analysis and troubleshooting ability.

Each of the equivalent mass units corresponds to a force vector time-varying motion equation of center of mass. The motion trajectory of each of the equivalent mass units in the satellite mechanical coordinate system reflects the deployment process of the reflector visually, a resultant moment of reaction moment vectors of the equivalent mass units greatly simplifies calculation of a satellite attitude motion in a control system, and the multiple time histories having redundant physical quantities changes facilitate the analysis and the rechecking.

In a case that there is the escapement, the escapement for controlling the release speed of the coil spring can make the deployment process of the reflector as steady as possible. In a case that there is no escapement, structure design of the reflector is simplified, which improves reliability, but the deployment process is faster under the drive of the coil spring. Therefore, in the simplified dynamics model, different force models of equivalent mass units are constructed according to different configurations, to ensure that an error generated when a force vector of the equivalent mass unit in the floating coordinate system is transformed into a force vector in the satellite body coordinate system is within an allowable range.

In step (6), a three-axis attitude angle and a three-axis attitude angular velocity obtained from the simulation analysis performed by the satellite control system design, test and analysis simulation software simulation analysis using the simplified model and the database in step (5) without momentum wheel for controlling satellite attitude (abbreviated as without wheel control) and without solar pressure disturbance moment on a solar wing or a satellite body (abbreviated as without solar pressure disturbance moment) are compared with a three-axis attitude angle and a three-axis attitude angular velocity obtained by the multi-body dynamics simulation software. In a case that a comparison result indicates that a relative error is within a range of -20% to +20%, the simplified model and the database for the deployment process of the antenna reflector which are provided to the control system design, test and analysis simulation software in step (5) is determined to meet a practical engineering application requirement. The range of -20% to +20% is a normally allowable error range of attitude parameter in practical engineering.

In step (7), in a case that the comparison result indicates that the relative error obtained by comparing the three-axis attitude angle and the three-axis attitude angular velocity obtained from simulation analysis performed by the satellite control system design, test and analysis simulation software using the simplified model and the database in step (5) without wheel control and solar pressure disturbance moment, with a three-axis attitude angle and a three-axis attitude angular velocity obtained by the multi-body dynamics simulation software exceeds the range of -20% to +20%, whether the database corresponding to the simplified dynamics model provided to the control system design, test and analysis simulation software is correct is further rechecked iteratively.

The recheck in step (7) includes steps (7a) to (7c).

In step (7a), correctness of signs and correctness of an order of magnitude of data on the ten time histories in the database in step (5) are verified.

In step (7b), correctness of the rotational inertia time history of the whole satellite relative to the satellite body coordinate system obtained in step (5) are verified based on mass of the whole satellite in initial operating condition setting of the multi-body dynamics simulation software and the rotational inertia time history of each of the equivalent mass units relative to the satellite body coordinate system. The whole satellite includes a pair of solar wings, a large antenna mast and a small antenna mast and the equivalent mass units of the reflector.

In step (7c), reasonability inverse verification is performed mutually on the position time history of each of the equivalent mass units in the satellite mechanical coordinate system, the position time history of center of mass of a whole satellite in the satellite mechanical coordinate system, the velocity time history of each of the equivalent mass units relative to the satellite mechanical coordinate system, the acceleration time history of each of the equivalent mass units relative to the satellite mechanical coordinate system, the reaction force vector time history of each of the equivalent mass units on the satellite, the reaction moment vector time history of each of the equivalent mass units on the satellite, and the resultant reaction moment vector time history of the equivalent mass units relative to the satellite body coordinate system, which are redundant with each other (for example, the position time history and the like can be derived from a known acceleration time history and time, and the acceleration time history can be derived from a known the position time history, which are the inverse verification).

The operation principle of the embodiment of the present disclosure is further explained and illustrated below with an example.

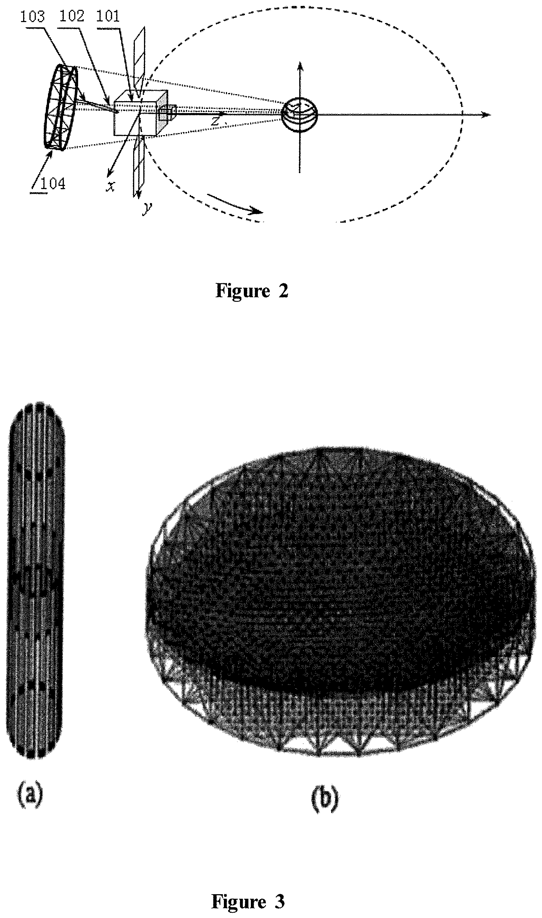

As shown in Figure 2, which is a schematic diagram of an in-orbit operating state of a satellite-borne truss antenna according to the embodiment, the flexible satellite-borne multi-body truss antenna mainly includes a large deployable mast 102, a small deployable mast 103, a reflector 104, and a focal-plane feed array. The antenna reflector includes a peripheral truss, a reflection net, a cable net, a coil spring, a cable (a drive cord 105), a T-shaped hinge 106 having a cable sheave, a synchronous hinge 109 having an escapement for controlling a release speed of the coil spring, a diagonal rod locking hinge including a sliding hinge and an in-position locking mechanism, a vertical rod 107 (the vertical rod 107 includes an even-numbered rod 17a and an odd-numbered rod 17b), and a transversal rod 108 (the transversal rod includes an upper transversal rod 18a and a lower transversal rod 18b). A satellite body 101 is fixed-point captured in a synchronous orbit, and the antenna, the large deployable mast and the small deployable mast are in a furled state. Upon receiving a remote antenna deployment control command from the ground, a hoop pressing mechanism is released, and the large mast is deployed and locked to a predetermined position under the drive of a motor, and then a pressing mechanism on the axis of the large mast releases, and the large mast rotates around its axis to be in a right place and is locked under the drive of the motor. Then, the small mast rotates around a rotational axis where the small mast is hinged to the large mast, to be locked in a right place. Then, a pyrotechnic cutter bundled in the periphery of the reflector detonates and cuts a wrapping tape of the antenna. The antenna reflector is deployed under the action of the coil spring first, meanwhile two drive motors installed on the antenna start withdrawing the cables (which are also referred to as drive cords) simultaneously. Deployment of the reflector no longer is not accelerated when driving moment of the coil spring is equal to a resistance moment. When the resistance moment is greater than the driving moment of the coli spring, the deployment of the reflector is decelerated and soon stopped. Then the motors drag the cables in the truss diagonal rods to drive the reflector to continue deploying, until the antenna reflector is fully deployed.

Figure 3 is schematic diagrams of a truss antenna reflector in a furled state and a deployed state according to the embodiment, in which Figure 3a is a schematic diagram of the reflector in the furled state, and Figure 3b is a schematic diagram of the reflector in a fully deployed state. It can be seen in Figure 3 that the diagonal rod of the reflector connected to the small mast has a maximum length in the furled state, and has a minimum length and is locked in the fully deployment state.

Figure 4 is a schematic diagram of a peripheral truss structure of the antenna reflector, the numbering of 30 vertical rods and a coordinate system according to the embodiment. The vertical rods 107 are illustrated in Figure 4, in which Figure 4a is a schematic diagram of arrangement of the vertical rods, Figure 4b shows a peripheral truss structure of the antenna reflector, Figure 4c is a top view of the 30 vertical rods including 15 even-numbered rods 17a and 15 odd-numbered rods 17b (the even-numbered rods 17a and the odd-numbered rods are arranged alternately), where 110 denotes a motor end, and Figure 4d is a partial schematic diagram of the vertical rods. It can be seen in Figure 4 that in multi-body dynamics simulation analysis, a component floating coordinate system is similar to a component mechanical coordinate system. An origin of the coordinate system is located at a theoretical circle center of a standard mounting hole in a mounting surface of the component, and directions of x, y, z axes may be chosen as needed, as long as conforming to definition of a right-handed rectangular coordinate system. A location dimension, a location of center of mass, and other feature dimension of the component are defined in the coordinate system.

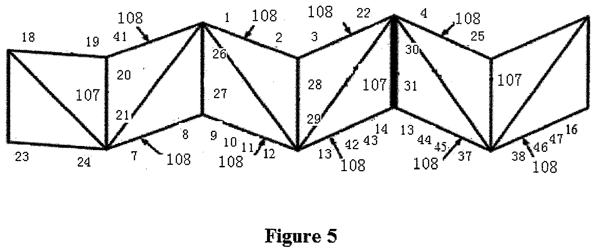

Figure 5 is a schematic diagram of positions of measuring points 1 to 50 during a deployment test of a truss antenna reflector according to the embodiment (numbers in Figure 5 represent positions of strain gages attached onto the measuring points, only a part of which are shown in Figure 5). A result of the multi-body dynamics simulation analysis is compared with a measurement result on the measuring points, and in a case that a relative error between the two results does not exceed +30%, a severity degree adopted in the simulation is within an allowable range.

The truss antenna reflector according to the embodiment includes 30 vertical rods, 60 transversal rods and 30 stretchable diagonal rods (including the sliding hinge and the in-position locking hinge, and the cable driven by the motor runs through the diagonal rod). Each jointing point of the vertical rods, the transversal rods and the stretchable diagonal rods is provided with a synchronous hinge having a large mass and subjecting to a driving force directly from the coil spring, or is provided with a T-shape hinge (including a cable sheave) which directly subjects to a driving force of the cable dragged by the motor. Therefore, 60 equivalent mass units are constructed with taking the 60 hinges as cores according to the embodiment.

How to obtain the simplified inertia time-varying and force time-varying dynamics model and the database for the satellite control system design, test and analysis simulation software are explained below, which mainly include (1) simplified dynamics model for deployment process of reflector, (2) initial operating condition setting for dynamic simulation analysis, (3) database corresponding to the simplified dynamics model, (4) modeling of driving moment of coil spring and driving force of cable driven by motor in a truss antenna reflector, and (5) definitions of coordinate systems.

(1) Simplified dynamics model for deployment process of reflector

The dynamics model is a simplified dynamics model compared with a flexibility dynamics model generally used in the control system design, test and analysis simulation software, for details of which reference may be made to dynamics equations (13-97) in Section 13.3 (Attitude control of satellite with flexible appendages) of "Satellite Attitude Dynamics and Control" (1st edition), Shancheng TU, Astronautic Publishing House, in December 2001.

Generally, more and higher orders of vibration mode of solar wing flexibility are taken into account in the control system design, test and analysis simulation software. Additionally, in a case that a large asymmetric appendage is provided to the satellite, and rotational inertia of the whole satellite relative to the satellite body coordinate system has a large inertia product, it is required for the control system design, test and analysis simulation software to take the inertia product into account.

In a case that a momentum wheel in a satellite control system operates in a zero momentum manner or in zero whole-satellite momentum manner, and no momentum wheel attitude control is performed in the deployment process of the reflector, both angular momentum h and an angular momentum change rate of the momentum wheel are set to be 0 in an original attitude dynamics equation in the control system design, test and analysis simulation software.

In a case that the reflector includes 30 vertical rods, 60 transversal rods, and 30 stretchable diagonal rods (including the sliding hinge and the in-position locking hinge, and the cable driven by the motor runs through the diagonal rod), and each jointing point of the vertical rods, the transversal rods and the stretchable diagonal rods is provided with a synchronous hinge having a large mass and directly subjecting to a driving moment from the coil spring, or is provided with the T-shape hinge (including a cable sheave) which directly subjects to a driving force from the cable dragged by the motor, 60 equivalent mass units are constructed with taking the 60 hinges as cores. The deployment process of the reflector is described by position time histories of the 60 equivalent mass units under the action of the driving force of the coil spring and the driving force of the cable dragged by the motion, and the satellite attitude is changed by reaction moment of the 60 equivalent mass units on the satellite.

To analyze deployment of the truss mesh antenna reflector, coupling of translation and rotation, an orbit angular velocity of the synchronous orbit, and an influence of propellant consumption on a mass property of the whole satellite in orbital transfer of a transfer orbit are taken into account in the multi-body dynamics simulation analysis. However, since the attitude is controlled by the momentum wheel in the deployment process of the reflector, propellant consumption is not taken into account in the attitude control, and influences of a solar pressure, the gravity and the geomagnetic field are not taken into account either.

Accordingly, an optimum simplified inertia time-varying and force time-varying dynamics model is obtained by, respectively replacing, in the original attitude dynamics equation in the control system design, test and analysis simulation software, a disturbance moment and an inertia matrix of the whole satellite relative to center of mass of the whole satellite in the original dynamics equation with the resultant reaction moment vector time history of each of the equivalent mass units relative to the satellite body coordinate system and the rotational inertia time history of the whole satellite relative to the satellite body coordinate system which are obtained with the multi-body dynamics simulation analysis.

In simulation analysis of the control system, factors not taken into account in the multi-body dynamics simulation analysis may be added as needed.

(2) Initial operating condition setting for dynamics simulation analysis

In a normal deployment process of the satellite-borne truss antenna reflector, both the large mast and the small mast of the satellite-borne antenna are deployed completely and locked in an initial state, and the reflector is in a furled state.

The satellite is located in the synchronous orbit, and initial values of a three-axis attitude and an angular velocity are set to 0.

Mass of the whole satellite (including a pair of solar wings, the large antenna mast and the small antenna mast and the equivalent mass units of the reflector) and an initial position of center of the mass in the satellite mechanical coordinate system are set.

Mass of each of the equivalent mass units and an initial position of each of the equivalent mass units in the satellite mechanical coordinate system are set.

An initial value of an inertia matrix of the whole satellite in the satellite body coordinate system is set.

During the deployment of the reflector, a normal direction of the solar wing is kept to be the same as a direction of the Z axis, and a flexibility parameter in the operating condition is selected for the solar wings without taking liquid sloshing of the propellant into account.

(3) Database corresponding to simplified dynamics model

The simplified dynamics model requires ten time histories in the deployment process of the reflector, that is, the inertia time-varying and force time-varying database required in the satellite control system design, test and analysis simulation software obtained in step (5), including:

①position time history of each of the 60 equivalent mass units in the satellite mechanical coordinate system;

②position time history of center of mass of the whole satellite in the satellite mechanical coordinate system;

③velocity time history of each of the 60 equivalent mass units relative to the satellite mechanical coordinate system;

④acceleration time history of each of the 60 equivalent mass units relative to the satellite mechanical coordinate system; and

⑤reaction force vector time history of each of the 60 equivalent mass units on the satellite, where an application point of the reaction force vector is a position of the equivalent mass unit in the satellite mechanical coordinate system.

Another five time histories can be deduced from the above five time histories, including:

⑥reaction moment vector time history of each of the 60 equivalent mass units relative to the satellite body coordinate system;

⑦rotational inertia time history of each of the 60 equivalent mass units relative to the satellite body coordinate system;

⑧angular momentum vector time history of each of the 60 equivalent mass units relative to the satellite body coordinate system;

⑨rotational inertia time history of the whole satellite relative to the satellite body coordinate system; and

⑩resultant reaction moment vector time history of the 60 equivalent mass units relative to the satellite body coordinate system.

In a case that there is the escapement, two pieces of data should be provided for each time history under the action of driving moment of the coil spring in each sampling period.

In a case that there is no escapement, only one piece of data should be provided for each time history under the action of driving moment of the coil spring in each sampling period.

In the deployment process of the reflector under the drive of the cables of the motor, only one piece of data should be provided for each the time history in each sampling period.

The added five time histories described above facilitates selecting most convenient input data in the control system design and test simulation analysis. The calculated resultant moment of reaction moment vectors of the equivalent mass units can be used to simplify a process of calculating the satellite attitude motion by the control system and save calculation time. Also, the added five time histories described above facilitates self-correction for data of the simplified dynamics model and verification of reasonability of a simulation result of the control system. For example, space curves of motion trajectories of the 60 equivalent mass units can be drawn based on the three-dimensional position time histories of the 60 equivalent mass units in the mechanical coordinate system.

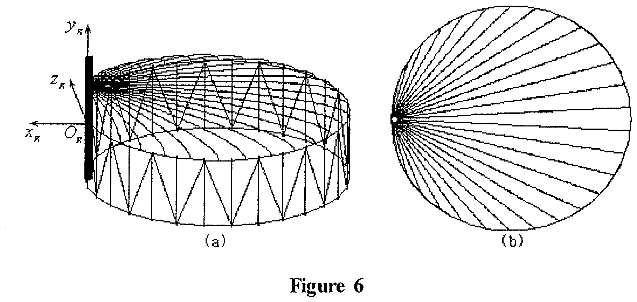

A motion trajectory and a force condition of any point can be obtained by the multi-body dynamics simulation analysis. Figure 6 is a front view and a top view of motion trajectories of centers of mass of upper rods (that is, the transversal rods) of the deployable truss in a reflector reference coordinate system in a deployment process according to the embodiment.

(4) Modeling of driving moment of coil spring and driving force of cable dragged by motor in the truss antenna reflector

In a case that the truss antenna reflector includes the escapement, a result of the multi-body dynamics simulation analysis indicates that the 60 equivalent mass units are accelerated and decelerated periodically under the control of the escapement and under the drive of the coil spring. For example, in each period of 10ms, the equivalent mass unit are accelerated at a uniform acceleration in a former half of the period, and decelerated to zero at a uniform acceleration in a latter half of the period.

In a case that the truss antenna reflector does not include an escapement, a result of the multi-body dynamics simulation analysis indicates that, in the 60 equivalent mass units under the action of driving moment of the coil spring, the synchronous hinge drives the truss rod, each angle between a vertical rod and a transversal rod changes to be approximate to 90°, and the diagonal rod is shortened. There are no acceleration and deceleration during a sampling period.

The 60 equivalent mass units are accelerated only if the driving moment of the coil spring is greater than resistance moment, and decelerated if the driving moment of the coil spring is less than the resistance moment, until the reflector deployment is completed. A difference between the driving moment and the resistance moment is given in the result of the multi-body dynamics simulation analysis.

In a case that there is no escapement, the deployment process of the reflector under the action of the driving moment of the coil spring takes a short time of tens of seconds. The equivalent mass units are accelerated at a uniform acceleration in each sampling period in a former time period, and decelerated at a uniform acceleration in each sampling period in a latter time period. A small sampling period is selected to meet the sampling theorem, which is not greater than 10ms.

When the driving moment of the coil spring is not great enough to drive the reflector to continue deploying, the 60 equivalent mass units are driven by the motor (pulling the cables in the diagonal rods). In this case, the cable sheave of the T-shape hinge is mainly stressed, forming force couple between adjacent vertical rods, to enable the truss of the reflector to be further deployed. When the diagonal rod moves into a locking position, an inner diagonal rod hit against a stop block. The stop block compress a damping material and an elastic material to decrease the relative velocity between the inner diagonal rod and an outer diagonal rod to be zero, and compress a locking block to enter into a groove of the outer diagonal rod, so as to lock the diagonal rod of the reflector.

All truss structures of the reflector are deployed almost synchronously under the action of the driving moment of the coil spring. The diagonal rods of the truss structures of the reflector are locked in sequence under the drive of the motor (pulling the cables in the diagonal rod).

The deployment process of the reflector under the drive of the motor includes a diagonal rod shortening period and a diagonal rod locking period. There are a forward increasing process and a reverse decreasing process for each of driving forces on the 60 equivalent mass units. The deployment process of the reflector under the drive of the motor consumes a long time.

In the diagonal rod shortening period, each equivalent mass unit is accelerated at a uniform acceleration in each sampling period.

In the diagonal rod locking period, the sampling period is not greater than 10ms, and each equivalent mass unit is decelerated at an opposite uniform acceleration in each sampling period, until being locked and has a zero velocity.

Because a direction of a force vector on each equivalent mass unit changes during deployment of the reflector, the model described with a constant acceleration force vector and a constant deceleration force vector in a same direction is a simplified model. Each of a position vector time history, a velocity vector time history, an acceleration vector time history, and a reaction force vector time history of the equivalent mass unit relative to the satellite mechanical coordinate system can be extracted from the result of the multi-body dynamics simulation analysis directly. According to the sampling theorem, simulation is performed in a sampling period small enough, so that the extracted time history directly has an allowed small error. The inverse solution method of motion characteristic equivalence is performed locally only to verify whether the selected sampling period of the multi-body dynamics simulation software is reasonable.

In a case that the velocity vector does not pass through the center of mass of the satellite body, motion of the equivalent mass unit includes an equivalent angular momentum change process in the sampling period.

(5) Definitions of coordinate systems

The satellite mechanical coordinate system is defined as follows.

a) The origin O is located in a mechanical separation plane between a bottom frame of the satellite and a launch vehicle, and coincides with a center of a theoretical circle composed by three dowels at an interface of the satellite;

b) The OX axis has a positive direction coincident with a theoretical external normal direction of an east board of the satellite;

c) The OY axis has a positive direction coincident with a theoretical external normal direction of a south board of the satellite;

d) The OZ axis is perpendicular to a connection and separation plane between the satellite and the launch vehicle, and has a positive direction pointing from the origin to a board facing to the earth; and

e) The OXYZ coordinate system conforms to the right-handed rule.

During in-orbit fight of the satellite, in a theoretical attitude condition, the body coordinate system (also referred to as an orbital coordinate system) as a satellite attitude base reference coordinate system is defined as follows.

a) The origin O is located at the center of mass of the satellite, where three axes $OX_b$, $OY_b$ and $OZ_b$ in the body coordinate system are respectively parallel with OX, OY and OZ in the mechanical coordinate system;

b) The OXb, as a roll axis, points to a satellite forward direction when the satellite is earth-oriented;

c) The OYb, as a pitch axis, points a negative normal direction of a satellite orbital plane when the satellite is earth-oriented;

The OZb, as a yaw axis, points to the earth center when the satellite is earth-oriented; and

The coordination system of $OX_bY_bZ_b$ conforms to the right-handed rule.

When the satellite flies in the synchronous orbit, the satellite forward direction is the true east direction, and the negative normal direction of the orbital plane is the true south direction. The body coordinate system as a satellite attitude base reference coordinate system is also referred to as an east-south coordinate system.

each time history under the action of driving moment of the coil spring in each sampling period.

In the deployment process of the reflector under the drive of the cables of the motor, only one piece of data should be provided for each the time history in each sampling period.

The added five time histories described above facilitates selecting most convenient input data in the control system design and test simulation analysis. The calculated resultant moment of reaction moment vectors of the equivalent mass units can be used to simplify a process of calculating the satellite attitude motion by the control system and save calculation time. Also, the added five time histories described above facilitates self-correction for data of the simplified dynamics model and verification of reasonability of a simulation result of the control system. For example, space curves of motion trajectories of the 60 equivalent mass units can be drawn based on the three-dimensional position time histories of the 60 equivalent mass units in the mechanical coordinate system.

A motion trajectory and a force condition of any point can be obtained by the multi-body dynamics simulation analysis. Figure 6 is a front view and a top view of motion trajectories of centers of mass of upper rods (that is, the transversal rods) of the deployable truss in a reflector reference coordinate system in a deployment process according to the embodiment.

(4) Modeling of driving moment of coil spring and driving force of cable dragged by motor in the truss antenna reflector

In a case that the truss antenna reflector includes the escapement, a result of the multi-body dynamics simulation analysis indicates that the 60 equivalent mass units are accelerated and decelerated periodically under the control of the escapement and under the drive of the coil spring. For example, in each period of 10ms, the equivalent mass unit are accelerated at a uniform acceleration in a former half of the period, and decelerated to zero at a uniform acceleration in a latter half of the period.

In a case that the truss antenna reflector does not include an escapement, a result of the multi-body dynamics simulation analysis indicates that, in the 60 equivalent mass units under the action of driving moment of the coil spring, the synchronous hinge drives the truss rod, each angle between a vertical rod and a transversal rod changes to be approximate to 90°, and the diagonal rod is shortened. There are no acceleration and deceleration during a sampling period.

The 60 equivalent mass units are accelerated only if the driving moment of the coil spring is greater than resistance moment, and decelerated if the driving moment of the coil spring is less than the resistance moment, until the reflector deployment is completed. A difference between the driving moment and the resistance moment is given in the result of the multi-body dynamics simulation analysis.

In a case that there is no escapement, the deployment process of the reflector under the action of the driving moment of the coil spring takes a short time of tens of seconds. The equivalent mass units are accelerated at a uniform acceleration in each sampling period in a former time period, and decelerated at a uniform acceleration in each sampling period in a latter time period. A small sampling period is selected to meet the sampling theorem, which is not greater than 10ms.

When the driving moment of the coil spring is not great enough to drive the reflector to continue deploying, the 60 equivalent mass units are driven by the motor (pulling the cables in the diagonal rods). In this case, the cable sheave of the T-shape hinge is mainly stressed, forming force couple between adjacent vertical rods, to enable the truss of the reflector to be further deployed. When the diagonal rod moves into a locking position, an inner diagonal rod hit against a stop block. The stop block compress a damping material and an elastic material to decrease the relative velocity between the inner diagonal rod and an outer diagonal rod to be zero, and compress a locking block to enter into a groove of the outer diagonal rod, so as to lock the diagonal rod of the reflector.

All truss structures of the reflector are deployed almost synchronously under the action of the driving moment of the coil spring. The diagonal rods of the truss structures of the reflector are locked in sequence under the drive of the motor (pulling the cables in the diagonal rod).

The deployment process of the reflector under the drive of the motor includes a diagonal rod shortening period and a diagonal rod locking period. There are a forward increasing process and a reverse decreasing process for each of driving forces on the 60 equivalent mass units. The deployment process of the reflector under the drive of the motor consumes a long time.

In the diagonal rod shortening period, each equivalent mass unit is accelerated at a uniform acceleration in each sampling period.

In the diagonal rod locking period, the sampling period is not greater than 10ms, and each equivalent mass unit is decelerated at an opposite uniform acceleration in each sampling period, until being locked and has a zero velocity.

Because a direction of a force vector on each equivalent mass unit changes during deployment of the reflector, the model described with a constant acceleration force vector and a constant deceleration force vector in a same direction is a simplified model. Each of a position vector time history, a velocity vector time history, an acceleration vector time history, and a reaction force vector time history of the equivalent mass unit relative to the satellite mechanical coordinate system can be extracted from the result of the multi-body dynamics simulation analysis directly. According to the sampling theorem, simulation is performed in a sampling period small enough, so that the extracted time history directly has an allowed small error. The inverse solution method of motion characteristic equivalence is performed locally only to verify whether the selected sampling period of the multi-body dynamics simulation software is reasonable.

In a case that the velocity vector does not pass through the center of mass of the satellite body, motion of the equivalent mass unit includes an equivalent angular momentum change process in the sampling period.

(5) Definitions of coordinate systems

The satellite mechanical coordinate system is defined as follows.

a) The origin O is located in a mechanical separation plane between a bottom frame of the satellite and a launch vehicle, and coincides with a center of a theoretical circle composed by three dowels at an interface of the satellite;

b) The OX axis has a positive direction coincident with a theoretical external normal direction of an east board of the satellite;

c) The OY axis has a positive direction coincident with a theoretical external normal direction of a south board of the satellite;

d) The OZ axis is perpendicular to a connection and separation plane between the satellite and the launch vehicle, and has a positive direction pointing from the origin to a board facing to the earth; and

e) The OXYZ coordinate system conforms to the right-handed rule.

During in-orbit fight of the satellite, in a theoretical attitude condition, the body coordinate system (also referred to as an orbital coordinate system) as a satellite attitude base reference coordinate system is defined as follows.

a) The origin O is located at the center of mass of the satellite, where three axes OXb, $OY_b$ and OZb in the body coordinate system are respectively parallel with OX, OY and OZ in the mechanical coordinate system;

b) The OXb, as a roll axis, points to a satellite forward direction when the satellite is earth-oriented;

c) The OYb, as a pitch axis, points a negative normal direction of a satellite orbital plane when the satellite is earth-oriented;

The OZb, as a yaw axis, points to the earth center when the satellite is earth-oriented; and

The coordination system of OXbYbZb conforms to the right-handed rule.

When the satellite flies in the synchronous orbit, the satellite forward direction is the true east direction, and the negative normal direction of the orbital plane is the true south direction. The body coordinate system as a satellite attitude base reference coordinate system is also referred to as an east-south coordinate system.

Content not described in details in the present disclosure are contents well known by those skilled in the art.

## Claims

1. A truss antenna reflector deployment dynamics modeling computer implemented method based on a multi-body analysis test, comprising:

    step (1), performing a deployment test on a flexible multi-body truss antenna reflector of a satellite, to obtain measurement data on force, moment and stress at measuring points of the truss antenna reflector during the deployment test;
    step (2), building multi-body dynamics simulation software and model based on characteristics of components of the truss antenna reflector, and performing simulation of the deployment process of the satellite's truss antenna reflector, to obtain simulation analysis data on the force, the moment and the stress of the same measuring points defined in step (1);
    step (3), comparing the simulation analysis data obtained through the simulation in step (2) with the measurement data obtained through the deployment test in step (1), and in a case that a comparison result indicates that a relative error between the simulation analysis data and the measurement data exceeds a predetermined threshold range A, optimizing the multi-body dynamics simulation model built in step (2) by rechecking whether a structure design parameter of each of the components in the reflector in the multi-body dynamics simulation model is correct;
    step (4), in a case that the comparison result indicates that the relative error does not exceed the predetermined threshold range A, analyzing whether a physical process of satellite attitude change obeys physical laws; and in a case that the physical process of satellite attitude change does not obey the physical laws, optimizing the multi-body dynamics simulation model built in step (2) by rechecking whether the structure design parameter of each of the components in the reflector in the multi-body dynamics simulation model is correct, wherein the analyzing whether the physical process of satellite attitude change obeys physical laws comprises: analyzing whether an angular momentum of the satellite obeys the law of angular momentum conservation and whether the motion trajectory of center of mass of each of the components coincides with a motion trajectory of center of mass of each of the components in a normal or anomaly antenna reflector deployment in multi-body dynamics simulation;
    step (5), constructing a plurality of equivalent mass units from the components of the reflector by combining each hinge of the reflector as a core with an adjacent transversal rod, an adjacent vertical rod and an adjacent diagonal rod; calculating, using the multi-body dynamics simulation software, a position time history, a velocity time history, an acceleration time history, and an acting force vector time history of the center of mass of each of the equivalent mass units; and obtaining, through coordinate transformation, a simplified inertia time-varying and force time-varying dynamics model and a database needed in satellite control system design, test and analysis simulation software;

wherein the database comprises a position time history of each of the equivalent mass units in a satellite mechanical coordinate system, a position time history of center of mass of the satellite in the satellite mechanical coordinate system, a velocity time history of each of the equivalent mass units relative to the satellite mechanical coordinate system, an acceleration time history of each of the equivalent mass units relative to the satellite mechanical coordinate system, a reaction force vector time history of each of the equivalent mass units on the satellite, a reaction moment vector time history of each of the equivalent mass units relative to a satellite body coordinate system, a moment of inertia time history of each of the equivalent mass units relative to the satellite body coordinate system, an angular momentum vector time history of each of the equivalent mass units relative to the satellite body coordinate system, a moment of inertia time history of the satellite relative to the satellite body coordinate system, and a resultant reaction moment vector time history of the equivalent mass units relative to the satellite body coordinate system, and

the simplified dynamics model is obtained by replacing a disturbance moment and an inertia matrix of the satellite relative to the center of mass of the satellite in an attitude dynamics equation of satellite with the resultant reaction moment vector time history of the equivalent mass units relative to the satellite body coordinate system and the moment of inertia time history of the satellite relative to the satellite body coordinate system obtained from the analysis by the multi-body dynamics simulation model, wherein the attitude dynamics equation of satellite is formulated as the following:

$$m_T \frac{dV_T}{dt} + \sum_{i=1}^{m} \underline{\beta}_{ti} \ddot{q}_i = F$$

$$\underline{\underline{I}}_T \dot{\omega} + \dot{h} + \omega \times h + \sum_{i=1}^{m} \underline{\beta}_{ri} \ddot{q}_i = T_{SAT}$$

$$\ddot{q}_i + 2 \underline{\rho}_i \underline{\underline{\Lambda}}_i \dot{q}_i + \underline{\underline{\Lambda}}_i^2 q_i + \underline{\beta}_{ti}^T \frac{dV}{dt} + \underline{\beta}_{ri}^T \dot{\omega} = 0$$

,

wherein $m_T$ represents mass of the satellite, $V_T$ represents a velocity of center of mass of the satellite having no deformed flexible appendage and is a three-dimensional vector, h represents angular momentum of a momentum wheel and is a three-dimensional vector, qi represents modal coordinates of the i-th flexible appendage and is a m-dimensional vector, $\underline{\beta}_{ti}$ represents a translational coupling coefficient of the i-th flexible appendage, $\underline{\beta}_{ri}$ represents a rotational coupling coefficient of the i-th flexible appendage, F represents an external force on the satellite, $\underline{\rho}_i$ represents a modal damping ratio of the i-th flexible appendage, $\underline{\Lambda}_i$ represents a modal frequency of the i-th flexible appendage, m represents the number of modal coordinates of the flexible appendages, $\underline{\beta}_{ti}$ $\underline{\beta}_{ri}$ and $\underline{\rho}_i$ are obtained with a finite element method, $\omega$ represents an attitude angular velocity, V represents a translational velocity of the satellite, $T_{SAT}$ represents the disturbance moment and $I_T$ represents the inertia matrix of the satellite relative to the center of mass of the satellite;

step (6), comparing a three-axis attitude angle and a three-axis attitude angular velocity obtained from simulation analysis performed by the satellite control system design, test and analysis simulation software using the simplified dynamics model and the database in step (5) without wheel control and solar pressure disturbance moment, respectively with a three-axis attitude angle and a three-axis attitude angular velocity obtained by the multi-body dynamics simulation model, determining whether a relative error obtained by the comparing exceeds a predetermined threshold range B, and going to step (7) in a case that the relative error exceeds the predetermined threshold range B, otherwise, going to step (8);

step (7), iteratively rechecking whether the database corresponding to the simplified dynamics model provided to the control system design, test and analysis simulation software is correct; and

step (8), regulating an attitude of the satellite by a control system of the satellite, wherein the control system is designed, tested and analyzed based on simulation performed with the simplified dynamics model.

2. The truss antenna reflector deployment dynamics modeling method based on the multi-body analysis test according to claim 1, wherein in step (2), the characteristics of the components at least comprise characteristics of a reflector coil spring passive drive mechanism, characteristics of a cable sheave active drive mechanism, and friction characteristics of a typical hinge .

3. The truss antenna reflector deployment dynamics modeling method based on the multi-body analysis test according to claim 1, wherein the predetermined threshold range A in steps (3) and (4) is from -30% to +30%.

4. The truss antenna reflector deployment dynamics modeling method based on the multi-body analysis test according to claim 1, wherein the predetermined threshold range B in steps (6) and (7) is from -20% to +20%.

5. The truss antenna reflector deployment dynamics modeling method based on the multi-body analysis test according to claim 1, wherein in step (5), the position time history, the velocity time history, the acceleration time history of center of mass, and the acting force vector time history of the center of mass of each of the equivalent mass units are calculated by the multi-body dynamics simulation software using Runge-Kutta method, wherein whether a selected sampling period of the Runge-Kutta method used by the multi-body dynamics simulation software is reasonable is verified using a difference solution method of motion characteristic equivalence.

6. The truss antenna reflector deployment dynamics modeling method based on the multi-body analysis test according to claim 5, wherein a detailed implementation for verifying whether the selected sampling period of the Runge-Kutta method is reasonable using the difference solution method of motion characteristic equivalence comprises:

obtaining an initial position, an ending position and an initial velocity of a sampling period based on the position time history and the velocity time history of center of mass of the equivalent mass unit;

calculating an approximate uniform acceleration of position equivalence in the sampling period according to a linear motion equation; and

determining that the sampling period is selected reasonably in a case that an error between the approximate uniform acceleration in the sampling period and an acceleration obtained with the Runge-Kutta method used by the multi-body dynamics simulation software is smaller than 20%.

7. The truss antenna reflector deployment dynamics modeling method based on the multi-body analysis test according to claim 1, wherein in the step (7), the rechecking comprises:

step (7a), verifying correctness of signs and correctness of an order of magnitude of data on the position time history of each of the equivalent mass units in a satellite mechanical coordinate system, the position time history of center of mass of a the satellite in the satellite mechanical coordinate system, the velocity time history of each of the equivalent mass units relative to the satellite mechanical coordinate system, the acceleration time history of each of the equivalent mass units relative to the satellite mechanical coordinate system, the reaction force vector time history of each of the equivalent mass units on the satellite, the reaction moment vector time history of each of the equivalent mass units relative to a satellite body coordinate system, the moment of inertia time history of each of the equivalent mass units relative to the satellite body coordinate system, the angular momentum vector time history of each of the equivalent mass units relative to the satellite body coordinate system, the moment of inertia time history of the satellite relative to the satellite body coordinate system, and the resultant reaction moment vector time history of the equivalent mass units relative to the satellite body coordinate system in the database in step (5);

step (7b), verifying correctness of the moment of inertia time history of the satellite relative to the satellite body coordinate system obtained in step (5), based on mass of the satellite in initial operating condition setting of the multi-body dynamics simulation software and the moment of inertia time history of each of the equivalent mass units relative to the satellite body coordinate system, wherein the satellite comprises a pair of solar wings, a large antenna mast, a small antenna mast and the equivalent mass units of the reflector; and

step (7c), mutually difference-verifying reasonability of each two of the position time history of each of the equivalent mass units in the satellite mechanical coordinate system, the velocity time history of each of the equivalent mass units relative to the satellite mechanical coordinate system, and the acceleration time history of each of the equivalent mass units relative to the satellite mechanical coordinate system, difference-verifying reasonability of the position time history of the center of mass of the satellite in the satellite mechanical coordinate system based on position time histories of the equivalent mass units in the satellite mechanical coordinate system, velocity time histories of the equivalent mass units relative to the satellite mechanical coordinate system or acceleration time histories of the equivalent mass units relative to the satellite mechanical coordinate system, and difference-verifying reasonability of the resultant reaction moment vector time history of the equivalent mass units relative to the satellite body coordinate system based on reaction moment vector time histories of the equivalent mass units on the satellite,

wherein the position time history of each of the equivalent mass units in the satellite mechanical coordinate system, the velocity time history of each of the equivalent mass units relative to the satellite mechanical coordinate system and the acceleration time history of each of the equivalent mass units relative to the satellite mechanical coordinate system are redundant with each other, the position time histories of the equivalent mass units in the satellite mechanical coordinate system, the velocity time histories of the equivalent mass units relative to the satellite mechanical coordinate system and the acceleration time histories of the equivalent mass units relative to the satellite mechanical coordinate system each are a redundancy backup of the position time history of the center of mass of the satellite in the satellite mechanical coordinate system, the reaction moment vector time histories of the equivalent mass units on the satellite are a redundancy backup of the resultant reaction moment vector time history of the equivalent mass units relative to the satellite body coordinate system, and difference-verifying reasonability of a time history to be verified comprises calculating a time history of the same type as the time history to be verified from a corresponding time history and checking whether a difference between the time history as calculated and the time history to be verified is within a predetermined range.

## Patentansprüche

1. Computerimplementiertes Verfahren zur Modellierung der Einsatzdynamik eines Gitterantennenreflektors auf der Grundlage eines Multikörperanalysetests umfassend:

Schritt (1), Durchführen eines Einsatztests an einem flexiblen Multikörper-Gitterantennenreflektors eines Satelliten, um Messdaten über Kraft, Moment und Spannung an Messpunkten des Gitterantennenreflektors während des Einsatztests zu erhalten;

Schritt (2), Aufbau einer Multikörperdynamik-Simulationssoftware und eines Modells auf der Grundlage von Eigenschaften der Komponenten des Gitterantennenreflektors, und Durchführen einer Simulation des Einsatzprozesses des Gitterantennenreflektors des Satelliten, um Simulationsanalysedaten über die Kraft, das Moment und die Spannung der gleichen Messpunkte zu erhalten, die in Schritt (1) definiert wurden;

Schritt (3), Vergleichen der Simulationsanalysedaten, die durch die Simulation in Schritt (2) erhalten wurden, mit den Messdaten, die durch den Einsatztest in Schritt (1) erhalten wurden, und in einem Fall, in dem ein Vergleichsergebnis anzeigt, dass ein relativer Fehler zwischen den Simulationsanalysedaten und den Messdaten einen vorbestimmten Schwellenwertbereich A überschreitet, Optimieren des in Schritt (2) aufgebauten Multikörperdynamik-Simulationsmodells durch erneutes Prüfen, ob ein Strukturdesignparameter jeder der Komponenten in dem Reflektor in dem MultikörperdynamikSimulationsmodell korrekt ist;

Schritt (4), in einem Fall, in dem das Vergleichsergebnis anzeigt, dass der relative Fehler den vorbestimmten Schwellenwertbereich A nicht überschreitet, Analysieren, ob ein physikalischer Prozess der Satellitenlageänderung physikalischen Gesetzen gehorcht; und in einem Fall, in dem der physikalische Prozess der Satellitenlageänderung den physikalischen Gesetzen nicht gehorcht, Optimieren des in Schritt (2) aufgebauten Multikörperdynamik-Simulationsmodells durch erneutes Prüfen, ob der Strukturdesignparameter jeder der Komponenten in dem Reflektor in dem MultikörperdynamikSimulationsmodell korrekt ist, wobei das Analysieren, ob der physikalische Prozess der Satellitenlageänderung physikalischen Gesetzen gehorcht, umfasst Analysieren, ob ein Drehimpuls des Satelliten dem Gesetz der Drehimpulserhaltung gehorcht und ob die Bewegungstrajektorie des Massenschwerpunkts jeder der Komponenten mit einer Bewegungstrajektorie des Massenschwerpunkts jeder der Komponenten bei einem normalen oder anomalen Antennenreflektoreinsatz in der Multikörperdynamiksimulation übereinstimmt;

Schritt (5), Konstruieren einer Vielzahl von äquivalenten Masseneinheiten aus den Komponenten des Reflektors durch Kombinieren jedes Gelenks des Reflektors als Kern mit einem benachbarten Querstab, einem benachbarten Vertikalstab und einem benachbarten Diagonalstab; Berechnen, unter Verwendung der Multikörperdynamik-Simulationssoftware, eines zeitlichen Verlaufs der Position, eines zeitlichen Verlaufs der Geschwindigkeit, eines zeitlichen Verlaufs der Beschleunigung des Massenschwerpunkts und eines zeitlichen Verlaufs des Vektors der wirkenden Kraft des Massenschwerpunkts jeder der äquivalenten Masseneinheiten; und Erhalten, durch Koordinatentransformation, eines vereinfachten Trägheitszeitvariations- und Kraftzeitvariationsdynamikmodells und einer Datenbank, die in der Satellitenkontrollsystementwurf-, Test- und Analysesimulationssoftware benötigt wird;

wobei die Datenbank einen Positionszeitverlauf jeder der äquivalenten Masseneinheiten in einem mechanischen Satellitenkoordinatensystem, einen zeitlichen Verlauf der Position des Massenschwerpunkts des Satelliten in dem mechanischen Satellitenkoordinatensystem, einen zeitlichen Verlauf der Geschwindigkeit jeder der äquivalenten Masseneinheiten relativ zu dem mechanischen Satellitenkoordinatensystem, einen zeitlichen Verlauf der Beschleunigung jeder der äquivalenten Masseneinheiten relativ zu dem mechanischen Satellitenkoordinatensystem, einen zeitlichen Verlauf des Reaktionskraftvektors jeder der äquivalenten Masseneinheiten auf dem Satelliten, einen zeitlichen Verlauf des Reaktionsmomentvektors jeder der äquivalenten Masseneinheiten relativ zu einem Satellitenkörper-Koordinatensystem, einen zeitlichen Verlauf des Trägheitsmoments jeder der äquivalenten Masseneinheiten relativ zum Satellitenkörper-Koordinatensystem, einen zeitlichen Verlauf des Drehimpulsvektors jeder der äquivalenten Masseneinheiten relativ zum Satellitenkörper-Koordinatensystem, einen zeitlichen Verlauf des Trägheitsmoments des Satelliten relativ zum Satellitenkörper-Koordinatensystem, und einen resultierenden zeitlichen Verlauf des Reaktionsmomentvektors der äquivalenten Masseneinheiten relativ zum Satellitenkörper-Koordinatensystem umfasst, und

wobei das vereinfachte Dynamikmodell erhalten wird, indem ein Störungsmoment und eine Trägheitsmatrix des Satelliten relativ zum Massenschwerpunkt des Satelliten in einer Lagedynamikgleichung des Satelliten durch den resultierenden zeitlichen Verlauf des Reaktionsmomentvektors der äquivalenten Masseneinheiten relativ zum Satellitenkörper-Koordinatensystem und den zeitlichen Verlauf des Trägheitsmoments des Satelliten relativ zum Satellitenkörper-Koordinatensystem, die aus der Analyse durch das Multikörperdynamik-Simulationsmodell erhalten werden, ersetzt werden, wobei die Lagedynamikgleichung des Satelliten wie folgt formuliert ist:

$$m_T \frac{dV_T}{dt} + \sum_{i=1}^{m} \underline{\beta}_{ti} \ddot{q}_i = F$$

$$\underline{\underline{I}}_T \dot{\omega} + \dot{h} + \omega \times h + \sum_{i=1}^{m} \underline{\beta}_{ri} \ddot{q}_i = T_{SAT}$$

$$\ddot{q}_i + 2\underline{\underline{\rho}}_i \underline{\underline{\Lambda}}_i \dot{q}_i + \underline{\underline{\Lambda}}_i^2 q_i + \underline{\beta}_{ti}^T \frac{dV}{dt} + \underline{\beta}_{ri}^T \dot{\omega} = 0$$

wobei $m_T$ die Masse des Satelliten darstellt, $V_T$ die Geschwindigkeit des Massenschwerpunkts des Satelliten ohne verformtes flexibles Anhängsel darstellt und ein dreidimensionaler Vektor ist, h den Drehimpuls eines Impulsrads darstellt und ein dreidimensionaler Vektor ist, $q_i$ die modalen Koordinaten des i-ten flexiblen Anhängsels darstellt und ein m-dimensionaler Vektor ist, $\underline{\beta}_{ti}$ einen translatorischen Kopplungskoeffizienten des i-ten flexiblen Anhängsels darstellt, $\underline{\beta}_{ri}$ einen rotatorischen Kopplungskoeffizienten des i-ten flexiblen Anhängsels darstellt, F eine äußere Kraft auf den Satelliten darstellt, $\rho_i$ ein modales Dämpfungsverhältnis des i-ten flexiblen Anhängsels darstellt, $\underline{\Lambda}_i$ eine modale Frequenz des i-ten flexiblen Anhängsels darstellt, m die Anzahl der modalen Koordinaten der flexiblen Anhängsel darstellt, wobei $\underline{\beta}_{ti}$, $\underline{\beta}_{ri}$, und $\rho_i$ mit der Finite-Elemente-Methode berechnet werden, wobei $\omega$ für die Lagewinkelgeschwindigkeit steht, wobei V für die Translationsgeschwindigkeit des Satelliten steht, wobei $T_{SAT}$ für das Störungsmoment und $I_T$ für die Trägheitsmatrix des Satelliten relativ zum Massenschwerpunkt des Satelliten stehen;

Schritt (6), Vergleichen eines dreiachsigen Lagewinkels und einer dreiachsigen Lagewinkelgeschwindigkeit, die aus der Simulationsanalyse erhalten werden, die von der Satellitenkontrollsystementwurf-, Test- und Analysesimulationssoftware unter Verwendung des vereinfachten Dynamikmodells und der Datenbank in Schritt (5) ohne Radsteuerung und Sonnendruckstörungsmoment durchgeführt wird, bzw. mit einem dreiachsigen Lagewinkel und einer dreiachsigen Lagewinkelgeschwindigkeit, die durch das Multikörperdynamiksimulationsmodell erhalten werden, Bestimmen, ob ein durch den Vergleich erhaltener relativer Fehler einen vorbestimmten Schwellenwertbereich B überschreitet, und Weitergehen zu Schritt (7) in einem Fall, dass der relative Fehler den vorbestimmten Schwellenwertbereich B überschreitet, andernfalls Weitergehen zu Schritt (8);

Schritt (7), iterativ Überprüfen, ob die Datenbank, die dem vereinfachten Dynamikmodell entspricht, das der Satellitenkontrollsystementwurf-, Test- und Analysesimulationssoftware zur Verfügung gestellt wird, korrekt ist; und

Schritt (8), Regulieren einer Lage des Satelliten durch ein Steuersystem des Satelliten, wobei das Steuersystem auf der Grundlage einer mit dem vereinfachten Dynamikmodell durchgeführten Simulation entworfen, getestet und analysiert wird.

2. Verfahren zur Modellierung der Einsatzdynamik eines Gitterantennenreflektors auf der Grundlage eines Multikörperanalysetests nach Anspruch 1, wobei in Schritt (2) die Eigenschaften der Komponenten zumindest die Eigenschaften eines passiven Reflektor-Schraubenfeder-Antriebsmechanismus, die Eigenschaften eines aktiven Seilscheiben-Antriebsmechanismus und die Reibungseigenschaften eines typischen Gelenks umfassen.

3. Verfahren zur Modellierung der Einsatzdynamik eines Gitterantennenreflektors auf der Grundlage eines Multikörperanalysetests nach Anspruch 1, wobei der vorgegebene Schwellenwertbereich A in den Schritten (3) und (4) zwischen -30% und +30% liegt.

4. Verfahren zur Modellierung der Einsatzdynamik eines Gitterantennenreflektors auf der Grundlage eines Multikörperanalysetests nach Anspruch 1, wobei der vorgegebene Schwellenwertbereich B in den Schritten (6) und (7) zwischen -20% und +20% liegt.

5. Verfahren zur Modellierung der Einsatzdynamik eines Gitterantennenreflektors auf der Grundlage eines Multikörperanalysetests nach Anspruch 1, wobei in Schritt (5) der zeitliche Verlauf der Position, der zeitliche Verlauf der Geschwindigkeit, der zeitliche Verlauf der Beschleunigung des Massenschwerpunkts und der zeitliche Verlauf des Vektors der wirkenden Kraft des Massenschwerpunkts jeder der äquivalenten Masseneinheiten von der Multikörperdynamik-Simulationssoftware unter Verwendung des Runge-Kutta-Verfahrens berechnet werden, wobei unter Verwendung eines Differenzlösungsverfahrens der Bewegungskennwertäquivalenz überprüft wird, ob eine ausgewählte Abtastperiode des von der Multikörperdynamik-Simulationssoftware verwendeten Runge-Kutta-Verfahrens angemessen ist.

6. Verfahren zur Modellierung der Einsatzdynamik eines Gitterantennenreflektors auf der Grundlage eines Multikörperanalysetests nach Anspruch 5, wobei eine detaillierte Implementierung zur Überprüfung, ob die gewählte Abtastperiode des Runge-Kutta-Verfahrens angemessen ist, unter Verwendung des Differenzlösungsverfahrens der Bewegungskennwertäquivalenz umfasst:

Ermitteln einer Anfangsposition, einer Endposition und einer Anfangsgeschwindigkeit einer Abtastperiode auf der Grundlage des zeitlichen Verlaufs der Positions und des zeitlichen Verlaufs der Geschwindigkeit des Massenschwerpunkts der äquivalenten Masseneinheit;
Berechnen einer annähernd gleichmäßigen Beschleunigung der Positionsäquivalenz in der Abtastperiode gemäß einer linearen Bewegungsgleichung; und
Feststellen, dass die Abtastperiode vernünftig gewählt ist, wenn ein Fehler zwischen der annähernd gleichmäßigen Beschleunigung in der Abtastperiode und einer Beschleunigung, die mit dem von der Multikörperdynamik-Simulationssoftware verwendeten Runge-Kutta-Verfahren erhalten wird, kleiner als 20 % ist.

7. Verfahren zur Modellierung der Einsatzdynamik eines Gitterantennenreflektors auf der Grundlage eines Multikörperanalysetests nach Anspruch 1, wobei in Schritt (7) die Überprüfung umfasst:

Schritt (7a), Überprüfen der Richtigkeit der Vorzeichen und der Richtigkeit einer Größenordnung der Daten des zeitlichen Verlaufs der Position jeder der äquivalenten Masseneinheiten in einem mechanischen Satellitenkoordinatensystem, des zeitlichen Verlaufs der Position des Massenschwerpunkts des Satelliten in dem mechanischen Satellitenkoordinatensystem, des zeitlichen Verlaufs der Geschwindigkeit jeder der äquivalenten Masseneinheiten relativ zu dem mechanischen Satellitenkoordinatensystem, des zeitlichen Verlaufs der Beschleunigung jeder der äquivalenten Masseneinheiten relativ zu dem mechanischen Satellitenkoordinatensystem, des zeitlichen Verlaufs des Reaktionskraftvektors jeder der äquivalenten Masseneinheiten auf dem Satelliten, des zeitlichen Verlaufs des Reaktionsmomentvektors jeder der äquivalenten Masseneinheiten relativ zu einem Satellitenkörper-Koordinatensystem, des zeitlichen Verlaufs des Trägheitsmoments jeder der äquivalenten Masseneinheiten relativ zum Satellitenkörper-Koordinatensystem, des zeitlichen Verlaufs des Drehimpulsvektors jeder der äquivalenten Masseneinheiten relativ zum Satellitenkörper-Koordinatensystem, des zeitlichen Verlaufs des Trägheitsmoments des Satelliten relativ zum Satellitenkörper-Koordinatensystem und des resultierenden zeitlichen Verlaufs des Reaktionsmomentvektors der äquivalenten Masseneinheiten relativ zum Satellitenkörper-Koordinatensystem in der Datenbank in Schritt (5);
Schritt (7b), Verifizieren der Korrektheit des in Schritt (5) erhaltenen zeitlichen Verlaufs des Trägheitsmoments des Satelliten relativ zum Satellitenkörper-Koordinatensystem auf der Grundlage der Masse des Satelliten in der anfänglichen Betriebszustandseinstellung der Multikörperdynamik-Simulationssoftware und des zeitlichen Verlaufs des Trägheitsmoments jeder der äquivalenten Masseneinheiten relativ zum Satellitenkörper-Koordinatensystem, wobei der Satellit ein Paar Solarflügel, einen großen Antennenmast, einen kleinen Antennenmast und die äquivalenten Masseneinheiten des Reflektors umfasst; und

Schritt (7c), gegenseitiges Differenzverifizieren der Plausibilität von jeweils zwei der zeitlichen Verläufe der Position jeder der äquivalenten Masseneinheiten im mechanischen Satellitenkoordinatensystem, der zeitlichen Verlaufe der Geschwindigkeit jeder der äquivalenten Masseneinheiten relativ zum mechanischen Satellitenkoordinatensystem und der zeitlichen Verläufe der Beschleunigung jeder der äquivalenten Masseneinheiten relativ zum mechanischen Satellitenkoordinatensystem, Differenzverifizieren der Plausibilität des zeitlichen Verlauf der Position des Massenschwerpunkts des Satelliten im mechanischen Satellitenkoordinatensystem auf der Grundlage der zeitlichen Verläufe der Position der äquivalenten Masseneinheiten im mechanischen Satellitenkoordinatensystem, der zeitlichen Verläufe der Geschwindigkeit der äquivalenten Masseneinheiten relativ zum mechanischen Satellitenkoordinatensystem oder der zeitlichen Verläufe der Beschleunigung der äquivalenten Masseneinheiten relativ zum mechanischen Satellitenkoordinatensystem, und Differenzüberprüfen der Plausibilität des resultierenden zeitlichen Verlaufs des Reaktionsmomentvektors der äquivalenten Masseneinheiten relativ zum Satellitenkörperkoordinatensystem auf der Grundlage von zeitlichen Verläufen des Reaktionsmomentvektors der äquivalenten Masseneinheiten auf dem Satelliten,

wobei der zeitliche Verlauf der Position jeder der äquivalenten Masseneinheiten im mechanischen Satellitenkoordinatensystem, der zeitliche Verlauf der Geschwindigkeit jeder der äquivalenten Masseneinheiten relativ zum mechanischen Satellitenkoordinatensystem und der zeitliche Verlauf der Beschleunigung jeder der äquivalenten Masseneinheiten relativ zum mechanischen Satellitenkoordinatensystem miteinander redundant sind, wobei die zeitlichen Verläufe der Position der äquivalenten Masseneinheiten in dem mechanischen Satellitenkoordinatensystem, die zeitlichen Verläufe der Geschwindigkeit der äquivalenten Masseneinheiten relativ zu dem mechanischen Satellitenkoordinatensystem und die zeitlichen Verläufe der Beschleunigung der äquivalenten Masseneinheiten relativ zu dem mechanischen Satellitenkoordinatensystem jeweils eine Redundanzsicherung des zeitlichen Verlaufs der Position des Massenschwerpunkts des Satelliten in dem mechanischen Satellitenkoordinatensystem sind, die zeitlichen Verläufe des Reaktionsmomentvektors der äquivalenten Masseneinheiten auf dem Satelliten eine Redundanzsicherung des resultierenden zeitlichen Verlaufs des Reaktionsmomentvektors der äquivalenten Masseneinheiten relativ zu dem Satellitenkörper-Koordinatensystem sind, und das Differenzverifizieren der Plausibilität eines zu prüfenden zeitlichen Verlaufs das Berechnen eines zeitlichen Verlaufs des gleichen Typs wie der zu prüfende zeitliche Verlauf aus einem entsprechenden zeitlichen Verlauf und das Prüfen, ob eine Differenz zwischen dem berechneten zeitlichen Verlauf und dem zu prüfenden zeitlichen Verlauf innerhalb eines vorbestimmten Bereichs liegt, umfasst.

## Revendications

1.  Un procédé mis en œuvre par ordinateur de modélisation de la dynamique de déploiement d'un réflecteur d'antenne en treillis basé sur un essai d'analyse multi-corps, comprenant :

    l'étape (1), la réalisation d'un essai de déploiement sur un réflecteur d'antenne en treillis multi-corps flexible d'un satellite, pour obtenir des données de mesure sur la force, le moment et la contrainte au niveau de points de mesure du réflecteur d'antenne en treillis pendant l'essai de déploiement ;
    étape (2), la construction d'un logiciel de simulation de la dynamique multi-corps et d'un modèle basé sur des caractéristiques de composants du réflecteur d'antenne en treillis, et effectuer une simulation du procédé de déploiement du réflecteur d'antenne en treillis du satellite, afin d'obtenir des données d'analyse de simulation sur la force, le moment et la contrainte des mêmes points de mesure définis dans l'étrape (1);
    étape (3), la comparaison des données de l'analyse de simulation obtenues à travers la simulation dans l'étape (2) avec les données de mesure obtenues à travers l'essai de déploiement dans l'étape (1), et dans le cas où un résultat de la comparaison indique qu'une erreur relative entre les données de l'analyse de simulation et les données de mesure dépasse une plage de seuil prédéterminée A, optimiser le modèle de simulation de la dynamique multi-corps construit à l'étape (2) en revérifiant si un paramètre de conception de la structure de chacun des composants dans le réflecteur dans le logiciel de simulation de la dynamique multi-corps est correct ;
    étape (4), dans le cas où le résultat de la comparaison indique que l'erreur relative ne dépasse pas la plage de seuil prédéterminée A, analyser si un processus physique de changement d'attitude du satellite obéit aux lois de la physique, et dans le cas où le processus physique de changement d'attitude du satellite n'obéit pas aux lois de la physique, optimiser le modèle de simulation de la dynamique multi-corps construit à l'étape (2) en revérifiant si le paramètre de conception de structure de chacun des composants dans le réflecteur dans le modèle de simulation de la dynamique multi-corps est correct, dans lequel l'analyse pour savoir si le processus physique de changement d'attitude du satellite obéit aux lois de la physique comprend : l'analyse si le moment angulaire du satellite obéit à la loi de conservation du moment angulaire et si la trajectoire de mouvement du centre de masse de chacun des composants coïncide avec la trajectoire de mouvement du centre de masse de chacun des composants dans un déploiement de réflecteur d'antenne normal ou anormal dans la simulation de la dynamique multi-corps;

étape (5), la construction d'une pluralité d'unités de masse équivalente à partir des composants du réflecteur en combinant chaque charnière du réflecteur comme un noyau avec une tige transversale adjacente, une tige verticale adjacente et une tige diagonale adjacente; calculer, en utilisant le logiciel de simulation de la dynamique multi-corps, un historique dans le temps de position, un historique dans le temps de vitesse, un historique dans le temps d'accélération et un historique dans le temps de vecteur de force d'action du centre de masse de chacune des unités de masse équivalente ; et obtenir, à travers une transformation de coordonnées, un modèle de dynamique d'inertie variable dans le temps et de force variable dans le temps simplifié et une base de données nécessaire dans le logiciel de conception de système de commande, d'essai et d'analyse de la simulation;

dans lequel la base de données comprend un historique dans le temps de position de chacune des unités de masse équivalente dans un système de coordonnées mécaniques du satellite, un historique dans le temps de position du centre de masse du satellite dans le système de coordonnées mécaniques du satellite, un historique dans le temps de vitesse de chacune des unités de masse équivalentes par rapport au système de coordonnées mécaniques du satellite, un historique dans le temps d'accélération de chacune des unités de masse équivalentes par rapport au système de coordonnées mécaniques du satellite, un historique dans le temps du vecteur de force de réaction de chacune des unités de masse équivalentes par rapport au système de coordonnées mécaniques du satellite, un historique dans le temps du vecteur de moment d'angle de chacune des unités de masse équivalentes par rapport au système de coordonnées du corps du satellite, un historique dans le temps du moment d'inertie du satellite par rapport au système de coordonnées du corps du satellite, et un historique dans le temps du vecteur de moment de réaction résultant des unités de masse équivalente par rapport au système de coordonnées du corps du satellite, et

le modèle dynamique simplifié est obtenu en remplaçant un moment de perturbation et une matrice d'inertie du satellite par rapport au centre de masse du satellite dans une équation dynamique d'attitude du satellite par l'historique dans le temps du vecteur de moment de réaction résultant des unités de masse équivalentes par rapport au système de coordonnées du corps du satellite et l'historique dans le temps du moment d'inertie du satellite par rapport au système de coordonnées du corps du satellite obtenu à partir de l'analyse par le modèle de simulation de la dynamique multi-corps ; dans lequel l'équation de dynamique d'attitude du satellite est formulée comme suit:

$$m_T \frac{dV_T}{dt} + \sum_{i=1}^{m} \beta_{ti} \ddot{q}_i = F$$

$$I_T \dot{\omega} + \dot{h} + \omega \times h + \sum_{i=1}^{m} \beta_{ri} \ddot{q}_i = T_{SAT}$$

$$\ddot{q}_i + 2\rho_i \Lambda_i \dot{q}_i + \Lambda_i^2 q_i + \beta_{ti}^T \frac{dV}{dt} + \beta_{ri}^T \dot{\omega} = 0$$

dans laquelle $m_T$ représente la masse du satellite, $V_T$ représente une vitesse du centre de masse du satellite n'ayant pas d'appendice flexible déformé et est un vecteur tridimensionnel, $h$ représente le moment angulaire d'une roue d'inertie et est un vecteur tridimensionnel, $q_i$ représente les coordonnées modales du $i$-ième appendice flexible et est un vecteur à m dimensions, $\beta_{ti}$ représente un coefficient de couplage en translation du $i$-ième appendice flexible, $\beta_{ri}$ représente un coefficient de couplage en rotation du $i$-ième appendice flexible, F représente une force externe sur le satellite, $\rho_i$ représente un rapport d'amortissement modal du $i$-ième appendice flexible, $\Lambda_i$ représente une fréquence modale du $i$-ième appendice flexible, m représente le nombre de coordonnées modales des appendices flexibles, $\beta_{ti}$, $\beta_{ri}$ et $\rho_i$ sont obtenus par la méthode des éléments finis, $\omega$ représente la vitesse angulaire de l'attitude, V représente une vitesse de translation du satellite, $T_{SAT}$ représente le moment perturbateur et $I_T$ représente la matrice d'inertie du satellite par rapport au centre de masse du satellite; étape (6), la comparaison d'un angle d'attitude à trois axes et d'une vitesse angulaire d'attitude à trois axes obtenus à partir d'une analyse de la simulation effectuée par le logiciel de simulation de conception, d'essai et d'analyse de système de commande de satellite en utilisant le modèle de dynamique simplifié et la base de données à l'étape (5) sans commande de roue et moment de perturbation de pression solaire, respectivement avec un angle d'attitude à trois axes et une vitesse angulaire d'attitude à trois axes obtenus par le modèle de simulation de la dynamique multi-corps, déterminer si l'erreur relative obtenu par la comparaison dépasse une plage de seuil prédéterminée B, et aller vers l'étape (7) dans le cas où l'erreur relative dépasse la plage de seuil prédéterminée B; et dans l'autre cas, aller vers l'étape (8);

étape (7), revérifier de manière itérative si la base de données correspondant au modèle de dynamique simplifié fournie au logiciel de simulation de conception de système de commande, d'essai et d'analyse est correcte, et

étape (8), régler une attitude du satellite à travers un système de commande de satellite, dans lequel le système de commande est conçu, testé et analysé à base de la simulation effectuée avec le modèle de dynamique simplifié.

2. Le procédé de modélisation de la dynamique de déploiement d'un réflecteur d'antenne en treillis basé sur l'essai d'analyse multi-corps selon la revendication 1, dans lequel à l'étape (2), les caractéristiques des composants comprennent au moins les caractéristiques d'un mécanisme d'entraînement passif de ressort hélicoïdal de réflecteur, des caractéristiques d'un mécanisme d'entraînement actif de poulie de câble, et des caractéristiques de friction de charnière typique.

3. Le procédé de modélisation de la dynamique de déploiement d'un réflecteur d'antenne en treillis basé sur l'essai d'analyse multi-corps selon la revendication 1, dans lequel la plage de seuil prédéterminée A dans les étapes (3) et (4) est comprise entre -30% et +30%.

4. Le procédé de modélisation de la dynamique de déploiement d'un réflecteur d'antenne en treillis basé sur l'essai d'analyse multi-corps selon la revendication 1, dans laquelle la plage de seuil prédéterminée B dans les étapes (6) et (7) est comprise entre -20% et +20%.

5. Le procédé de modélisation de la dynamique de déploiement d'un réflecteur d'antenne en treillis basé sur l'essai d'analyse multi-corps selon la revendication 1, dans lequel à l'étape (5), l'historique dans le temps de la position, l'historique dans le temps de la vitesse, l'historique dans le temps de l'accélération du centre de masse et l'historique dans le temps du vecteur de force d'action du centre de masse de chacune des unités de masse équivalente sont calculés par le logiciel de simulation de la dynamique multi-corps en utilisant la méthode Runge-Kutta, dans lequel le fait qu'une période d'échantillonnage sélectionnée de la méthode Runge-Kutta utilisée par le logiciel de simulation de la dynamique multi-corps est raisonnable est vérifié en utilisant une méthode de solution de différence de l'équivalence de caractéristiques de mouvement.

6. Le procédé de modélisation de la dynamique de déploiement d'un réflecteur d'antenne en treillis basé sur l'essai d'analyse multi-corps selon la revendication 5, dans lequel une mise en oeuvre détaillée pour vérifier si la période d'échantillonnage sélectionnée de la méthode Runge-Kutta est raisonnable en utilisant la méthode de solution de différence de l'équivalence de caractéristiques de mouvement comprend :

obtenir une position initiale, une position finale et une vitesse initiale d'une période d'échantillonnage basée sur l'historique dans le temps de la position et l'historique dans le temps de la vitesse du centre de masse de l'unité de masse équivalente ;

calculer une accélération uniforme approximative de l'équivalence de position dans la période d'échantillonnage selon une équation de mouvement linéaire ; et

déterminer que la période d'échantillonnage est sélectionnée de manière raisonnable dans le cas où une erreur entre l'accélération uniforme approximative dans la période d'échantillonnage et une accélération obtenue avec la méthode Runge-Kutta utilisée par le logiciel de simulation de la dynamique multi-corps est inférieure à 20%.

7. Le procédé de modélisation de la dynamique de déploiement d'un réflecteur d'antenne en treillis basé sur l'essai d'analyse multi-corps selon la revendication 1, dans lequel dans l'étape (7), la revérification comprend :

l'étape (7a), la vérification de l'exactitude des signes et de l'exactitude d'un ordre de grandeur des données sur l'historique dans le temps de position de chaque unité de masse équivalente dans un système de coordonnées mécaniques de satellite, sur l'historique dans le temps de la position du centre de masse du satellite dans le système de coordonnées mécaniques du satellite, sur l'historique dans le temps de la vitesse de chacune des unités de masse équivalente par rapport au système de coordonnées mécaniques du satellite, sur l'historique dans le temps de l'accélération de chacune des unités de masse équivalente par rapport au système de coordonnées mécaniques du satellite, sur l'historique dans le temps du vecteur de force de réaction de chacune des unités de masse équivalente sur le satellite, sur l'historique dans le temps du vecteur de moment de réaction de chacune des unités de masse équivalente par rapport au système de coordonnées de corps du satellite, sur l'historique dans le temps du moment d'inertie de de chacune des unités de masse équivalente par rapport au système de coordonnées du corps du satellite, sur l'historique dans le temps vecteur du moment angulaire de chacune des unités de masse équivalente par rapport au système de coordonnées du corps du satellite, sur l'historique dans le temps du moment d'inertie du satellite par rapport au système de coordonnées du corps du satellite, et sur l'historique dans le temps du vecteur de moment de réaction résultant des unités de masse équivalente par rapport au système de coordonnées du corps du satellite dans l'étape (5) ;

l'étape (7b), la vérification de l'exactitude de l'historique dans le temps du moment d'inertie par rapport au système de coordonnées du corps du satellite dans l'étape (5), sur la base de la masse du satellite dans le réglage des conditions de fonctionnement initiales du logiciel de simulation de la dynamique multi-corps et de l'historique dans le temps du moment d'inertie de chacune des unités de masse équivalente par rapport au système de coordonnées du corps du satellite, dans lequel le satellite comprend une paire d'ailes solaires, un grand mât d'antenne, un petit mât d'antenne et les unités de masse équivalente du réflecteur ; et

l'étape (7c), la vérification par différence mutuelle de la vraisemblance de chaque deux de l'historique dans le temps de la position de chacune des unités de masse équivalente dans le système de coordonnées mécaniques du satellite, de l'historique dans le temps de la vitesse de chacune des unités de masse équivalente par rapport au système de coordonnées mécaniques du satellite, et de l'historique dans le temps de l'accélération de chacune des unités de masse équivalente par rapport au système de coordonnées mécaniques du satellite, de la vérification par différence de la vraisemblance de l'historique dans le temps de la position du centre de masse du satellite dans le système de coordonnées mécaniques du satellite sur la base des historiques dans le temps de position des unités de masse équivalente par rapport au système de coordonnées mécaniques du satellite, de l'historique dans le temps de la vitesse des unités de masse équivalente par rapport au système de coordonnées mécaniques du satellite ou de l'historique dans le temps de l'accélération des unités de masse équivalente par rapport au système de coordonnées mécaniques du satellite, et de la vérification par différence de la vraisemblance de l'historique dans le temps du vecteur de moment de réaction résultant des unités de masse équivalente par rapport au système de coordonnées du corps du satellite sur la base des historiques dans le temps du vecteur de moment de réaction des unités de masse équivalente,

dans lequel l'historique dans le temps de la position de chacune des unités de masse équivalente dans le système de coordonnées mécaniques du satellite, de l'historique dans le temps de la vitesse de chacune des unités de masse équivalente par rapport au système de coordonnées mécaniques du satellite, et de l'historique dans le temps de l'accélération de chacune des unités de masse équivalentes par rapport au système de coordonnées mécaniques du satellite sont redondantes l'une par rapport à l'autre, les historiques dans le temps de la position des unités de masse équivalente dans le système de coordonnées mécaniques du satellite, les historiques dans le temps de la vitesse des unités de masse équivalente par rapport au système de coordonnées mécaniques du satellite et les historiques dans le temps de l'accélération des unités de masse équivalente par rapport au système de coordonnées mécaniques du satellite sont chacune une sauvegarde de redondance de l'historique dans le temps de la position du centre de masse du satellite dans le système de coordonnées mécaniques du satellite, les historiques dans le temps du vecteur de moment de réaction des unités de masse équivalente sur le satellite sont une sauvegarde de redondance de l'historique dans le temps du vecteur de moment de réaction résultant des unités de masse équivalente par rapport au système de coordonnées de corps du satellite, et la vérification par différence de la vraisemblance d'un historique dans le temps à vérifier comprend calculer un historique dans le temps du même type qu'un historique dans le temps à être vérifié à partir d'un historique dans le temps correspondant et vérifier si une différence entre l'historique dans le temps comme calculé et l'historique dans le temps à être vérifié se situe dans une plage prédéterminée.

Perform a deployment test on a truss mesh antenna reflector by attaching a strain gage onto a key measuring point, to measure data on force, moment and stress of the key measuring point during the deployment test

Build multi-body dynamics simulation software for deployment of the reflector based on models of components in the truss mesh antenna reflector, and perform simulation analysis

Compare a Result of the simulation analysis performed on the key measuring point with a test result, and determine whether a relative error exceed a range of +30% to -30%

Yes → Further optimize multi-body dynamics simulation software and recheck a design parameter of each component

No

Analyze whether the deployment of the reflector and a physical process of satellite attitude change are reasonable

No → Further optimize multi-body dynamics simulation software and recheck a design parameter of each component

Yes

Obtain a simplified inertia time-varying and force time-varying dynamics model and a database needed by satellite control system design, test and analysis simulation software

Whether a relative error between a result of the control system design and test simulation and a result of the multi-body dynamics simulation is within a range of -20% to +20%

No → Further iteratively recheck whether the database corresponding to the simplified dynamics model provided to the control system design, test and analysis simulation software is correct

Yes

Determine that the simplified model and the database can meet a practical engineering requiremen

**Figure 1**

24

**Figure 2**

(a)                                    (b)

**Figure 3**

(4a)

(4b)

(4c)

(4d)

**Figure 4**

Figure 5

(a)

(b)

**Figure 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201510374365

**Non-patent literature cited in the description**

- Deployment analysis of large space antenna using flexible multibody dynamics simulation. *ACTA AS-TRONAUTICA,* 24 July 2000, vol. 47 (1), 19-26

- **SHANCHENG TU.** Satellite Attitude Dynamics and Control. Astronautic Publishing House, December 2001